Europäisches Patentamt

**European Patent Office**

**Office européen des brevets**

(11) Publication number : **0 471 509 A2**

## EUROPEAN PATENT APPLICATION

(21) Application number : **91307302.9**

(51) Int. Cl.⁵ : **G01R 33/34**

(22) Date of filing : **08.08.91**

(30) Priority : **17.08.90 US 570264**

(43) Date of publication of application :
**19.02.92 Bulletin 92/08**

(84) Designated Contracting States :
**DE FR GB NL**

(71) Applicant : **GENERAL ELECTRIC COMPANY**
**1 River Road**
**Schenectady, NY 12345 (US)**

(72) Inventor : **Prost, Robert William**
**N40 W32786 Wildwood Lane**
**Nashotah, Wisconsin 53058 (US)**

(74) Representative : **Pratt, Richard Wilson et al**
**London Patent Operation G.E. TECHNICAL**
**SERVICES CO. INC. Burdett House 15/16**
**Buckingham Street**
**London WC2N 6DU (GB)**

(54) **Split NMR coil with improved connector.**

(57)     A separable, or "split" type volume coil assembly is disclosed which incorporates an improved electrical connector to enable high quality factor, or "Q" quadrature output signals to be obtained from a split resonator housed in the coil assembly. The improved connector includes flat, gold plated copper plates, sandwiched between facing end surfaces of two separable case halves. The copper plates are each electrically bonded to an open end of the split resonator to complete the resonator circuit when the case halves are assembled together.

EP 0 471 509 A2

FIG.1.

## Background of the Invention

The field of the invention is separable volume coils for use in a nuclear magnetic resonance (NMR) apparatus and, more particularly, to such separable volume coils which produce two output signals in phase quadrature.

When performing an NMR study, it is often desirable to use a local coil which encloses a volume containing the area which is to be the subject of the NMR study. Volume coils are usually used, for example, when the area of interest is deep inside a human patient, i.e. farther away from the outer skin of the patient than the effective range, or field of view, of topological surface coils. Volume coils typically employ a case or housing to enclose a cylindrical or other volume enclosing type of resonator tuned to the frequency of interest for the NMR study. Volume coils of this type are often used, for example, to perform NMR studies on the limbs of human patients. The volume coil is therefore usually open on both ends to allow its placement over the limb. In many cases, however, it is either inconvenient or impossible to axially move the limb into the volume coil. For these cases, separable or "split" volume coils have been developed in which the volume coil may be split into two halves to facilitate placement around the limb. In that case, the limb may be simply laid into one of the volume coil halves, and then the other volume coil half may be placed thereon to complete the volume coil assembly.

Since the volume coil must surround the area of interest, a split volume coil assembly must provide separate parts of the resonator in each of the volume coil halves. As a result, it is further necessary to provide electrical connectors on the volume coil halves to complete the electrical connections between the separate resonator portions. The connectors used in prior split volume coils have included standard banana plugs and jacks, and "knife-type" sliding contacts. These prior types of connectors have proven to be unsuitable for two reasons. First of all, the known connectors substantially degrade the quality factor or "Q" of the resonator when the resonator is of a type which provides two outputs in phase quadrature. If only a single phase output is desired, the point on the resonator where the single phase output signal is obtained may be arranged such that at resonance the currents across the connectors are low or null, so that the loss due to the connectors does not significantly effect the Q of the resonator. The prior connectors have therefore proven to be satisfactory when only a single phase output is desired. However, it is well known in the art that volume coils, because of their circular geometry, are capable of producing outputs in phase quadrature which can then be combined to provide an overall gain in the signal-to-noise ratio available from the resonator. Unfortunately, prior attempts to use a resonator providing phase quadrature outputs in a split volume coil have been wholly unsuccessful. Because of the requirement for phase quadrature outputs, it is no longer possible to physically arrange the current nulls to exist across the connectors. Therefore, at least one of the output phases, which corresponds to one resonant "mode" of the resonator, has been found to suffer a severe degradation of Q for that resonant mode. As a result, prior split coils have either been limited to single phase outputs, or the degradation in signal quality when using quadrature outputs has simply been accepted.

The second disadvantage of prior connectors used for split volume coils is that they are highly prone to physical damage during handling and use. The banana plugs or knife blades previously used are relatively fragile, protruding members, which may be inadvertently struck on another object during handling, misaligned with the opposite mating case half during assembly, dropped, or otherwise mishandled during use, often resulting in breakage of the connector.

Therefore, a connector is needed for split volume coils which would provide for quadrature operation of the coil without degrading the signal quality, and which is further more mechanically resistant to breakage.

## Summary of the Invention

A coil assembly according to the invention includes a case having first and second facing surfaces, with the case being movable between a closed position in which the first and second facing surfaces are in close proximity to each other and an open position in which the first and second facing surfaces are separated from each other. A resonator is supported by the case and terminates in first and second electrically discontinuous open ends, with the first and second open ends being disposed in the vicinity of the first and second facing surfaces, respectively. At least one separable connector is included for establishing electrical contact between the first and second resonator open ends. The connector includes a first conductive plate electrically connected to the first resonator open end and disposed on the first facing surface, and a second conductive plate electrically connected to the second resonator open end and disposed on the second facing surface. The first and second condvctive plates are arranged in alignment with each other such that the first and second conductive plates are sandwiched between the first and second facing surfaces of the case when the case is in the closed position.

One advantage of the invention is improved electrical contact between the resonator open ends. The large area of contact afforded by sandwiching the conductive plates between the case end surfaces results in an extremely low resistance, low loss connection.

Because of the low loss provided by the invention, the quality factor, or "Q" of the resonator is improved, particularly for resonators which produce quadrature output signals.

Another advantage of the coil assembly according to the invention is a great tolerance to misalignment of the connectors utilized to connect the resonator open ends. Since contact is established over the entire surface of the conductive plates, even substantial misalignment would not significantly effect contact resistance.

Yet another advantage of the coil assembly according to the invention is improved mechanical reliability for the connectors utilized to connect the resonator open ends. The conductive plates present a low profile which is resistant to breakage. Further, the "sandwiching" action utilized in the connector is highly tolerant of imperfections and damage to the conductive plates.

The coil assembly may include a resilient pad positioned between the first facing surface and the first conductive plate so as to apply a resilient pressure holding the first and second conductive plates together when the case is in the closed position. The resilient pad further improves the electrical contact by maintaining a steady, resilient force pressing the conductive plates together.

The foregoing and other objects and advantages of the invention will appear from the following description. In the description, reference is made to the accompanying drawings which form a part hereof, and in which there is shown by way of illustration a preferred embodiment of the invention. Such embodiment does not necessarily represent the full scope of the invention, however, and reference is made therefore to the claims herein for interpreting the scope of the invention.

## Brief Description of the Drawings

FIG. 1 is a perspective view with some parts cut away of a coil assembly and connector according to the present invention;

FIG. 2 is a cross-sectional view taken on line 2-2 of Fig. 1;

FIG. 3 is a cross-sectional view taken on line 3-3 of Fig. 1;

FIG. 4 is a cross-sectional view taken on line 4-4 of Fig. 3; and

FIG. 5 is a cross-sectional view taken on line 5-5 of Fig. 1.

## Description of the Preferred Embodiment

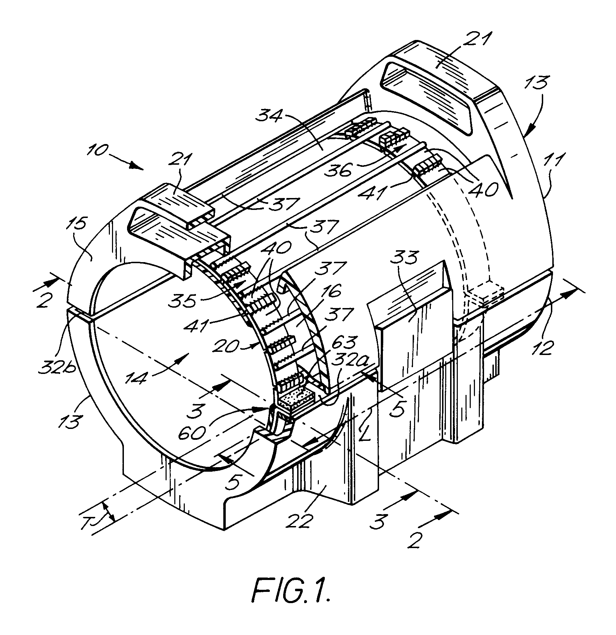

Referring to Fig. 1, a nuclear magnetic resonance (NMR) coil assembly 10 according to the invention includes two separable case halves 11 and 12 which, when placed together, form case 13. The case 13 encloses an interior volume, shown generally at 14, with both ends of the case 13 being open to the interior volume 14. The case halves 11 and 12 each consist of an outer shell 15 and a hollow interior 16. An NMR coil tuned to a resonant frequency of interest, referred to generally as a resonator 20, is disposed within the hollow interiors 16 of the case halves 11 and 12 in a manner described in detail below, for both physical protection for the resonator 20 and to present an attractive external appearance.

Each case half 11 and 12 has an approximately semi-circular shape, particularly along the interior volume 14 so as to support the cylindrically shaped resonator 20. The upper, or top case half 11 may be provided with handles 21 for ease of grasping the coil assembly 10, while the lower, or bottom case half 12 may be provided with an enlarged base 22, for example for particularly mating to a mounting jig (not shown) in an NMR apparatus. The semi-circular portions of each case half 11 and 12 terminate in two end surfaces, designated in Fig. 1 as 31a and 31b for the end surfaces on the upper case half 11, and as 32a and 32b for the end surfaces on the lower case half 12. Each end surface 31a, 31b, 32a and 32b is a generally rectangular area defined by the length L of the case halves 11 and 12, and the thickness T of the case walls. The two case halves 11 and 12 are assembled together by aligning the end surfaces 31 and 32 adjacent to and facing one another, i.e. with surface 31a and 32a facing one another and surfaces 31b and 32b facing one another. One or more alignment pins and mating holes (not shown) may be used for easily lining up the case halves 11 and 12 for assembly. In the assembled condition, the two case halves 11 and 12 are secured together by a pair of clamps 33 (only one of which is visible in Fig. 1) placed on opposite sides of the case 13 across the junctions between the case halves 11 and 12. An opening, or "window" 34 may optionally be provided on the top case half 11 to permit viewing of the interior volume 14, so as to confirm proper alignment of the area which is the subject of the NMR study in the interior volume 14.

The type of resonator 20 preferred for this embodiment is a "bird cage" coil, consisting of two coaxial end rings 35 and 36 bridged by a plurality of cross conductors 37. Each end ring 35 and 36 includes a plurality of conductive segments 40, with a gap 41 between each segment 40, and with each gap 41 being bridged by a capacitance, usually consisting of multiple individual chip capacitors 42 soldered across the gaps 41. The segments 40 themselves are copper strips approximately one inch wide and .004 inches thick. A total of 16 segments 40 are provided around a circle of approximately 6 7/8 inches in diameter, resulting in a circumferential length for each segment 40 of approximately 1.25 inches with a width of approximately 3/32 inches for each gap 31. The cross conductors 37 are copper tubes 1/8 inch in diameter and approximately 9 inches long, extending between the respective outside edges of end rings 35 and 36. The cross conductors 37 are soldered across corresponding segments 30 on the end rings 25 and 26.

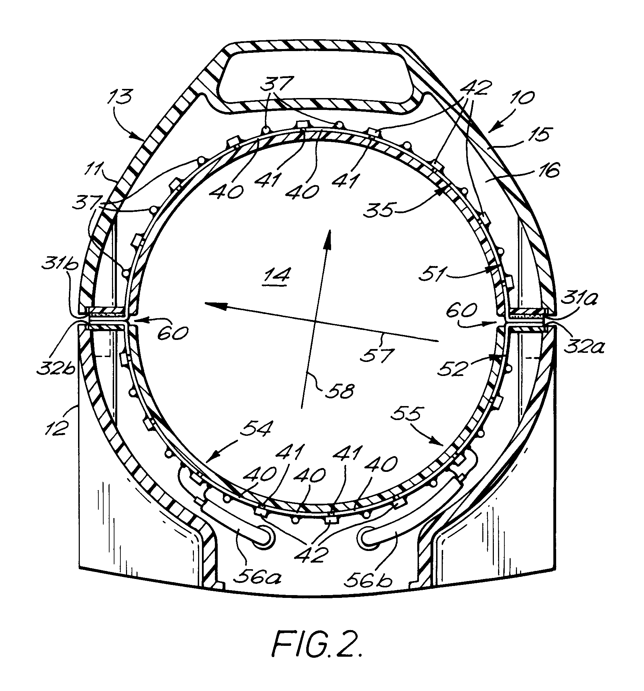

Referring momentarily to Fig. 2, the resonator 20 itself is also split into separable resonator halves 51 and 52, with each resonator half 51 and 52 being supported by one of the case halves 11 and 12, respectively. As described above, prior separable coil assemblies are usable only with a single phase output so that a current null can be arranged near the prior connectors used to join the prior resonator halves, thereby minimizing the effects of connector loss. However, bird cage, and other volume type resonators, are capable of producing orthogonal output signals by tapping energy from the resonator 20 at two points 60 and 61 disposed approximately 90° around the circumference of one of the end rings 35 or 36. A pair of output cables 60a and 60b are then used to conduct the orthogonal output signals to appropriate processing equipment (not shown). When used for phase quadrature operation, the resonator 20 presents two orthogonal resonant modes, as represented by phasors 62 and 63. Prior separable coil assemblies have been unable to fully exploit the quadrature signals available, due principally to the losses incurred in the prior connectors.

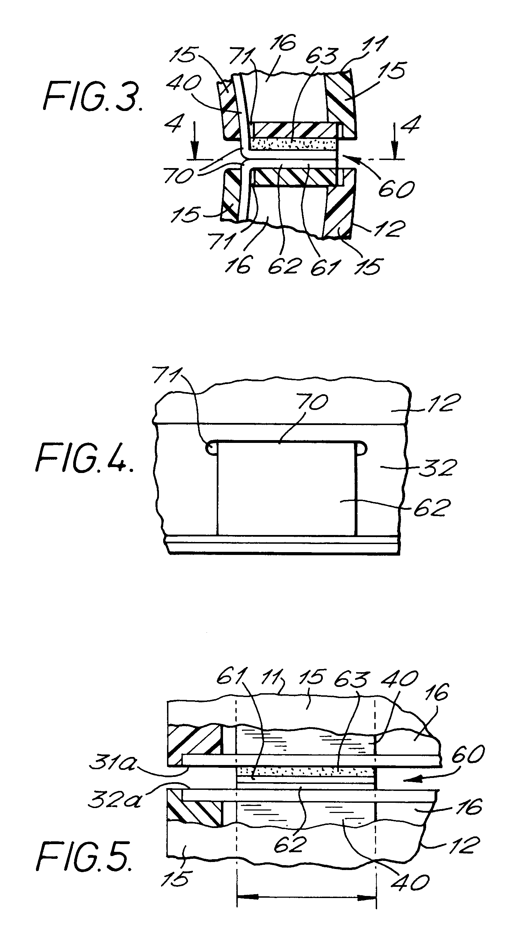

Referring to Figs. 2-5, a novel connector structure 60 according to the invention is utilized to electrically connect the resonator halves 51 and 52 together to complete the electrical circuit for the overall resonator 20 in a manner which permits phase quadrature output signals to be obtained with negligible degradation of the quality factor, or "Q" in either of the quadrature modes 62 and 63. Each end ring 35 and 36 is "split" to terminate in four open ends, two open ends on the upper resonator half 51 near end surfaces 31a and 31b, and two open ends on the lower resonator half 52 near end surfaces 32a and 32b. A total of four connectors 60 are therefore utilized to establish electric contact between the corresponding open ends of end rings 35 and 36 when the case halves 11 and 12 are assembled together.

The facing surfaces 31a/32a and 31b/32b which define the juncture between the two case halves 11 and 12 are utilized as an integral part in forming the connectors 60. Each connector 60 includes conductive plates 61 and 62 disposed between the facing surfaces 31 and 32. The conductive plates 61 and 62 utilized in this embodiment are solid copper, with rectangular dimensions of approximately one inch along the length of the end surface 31 or 32 by approximately 5/8 inches across the width of the end surface 31 or 32. Each lower conductive plate 62 is disposed directly on one end surface 32 of the lower case half 12. Each upper conductive plate 61 is mounted on a resilient pad 63, which is in turn disposed on one end surface 31 of the upper case half 11. The resilient pads 63 have approximately the same rectangular dimensions as the conductive plates 61 and 62, i.e. completely covering the top of plates 61, and are preferably formed of closed cell foam material.

When the case halves 11 and 12 are placed together, the conductive plates 61 and 62 are sandwiched together between the facing end surfaces 31 and 32. Upon engagement of the latches, the facing end surfaces 31 and 32 are forced together to a predetermined separation between them (approximately 1/16 inch in this embodiment), with the resilient pads 63 on top of the conductive plates 61 providing a resilient force for maintaining intimate contact between the conductive plates 61 and 62. The conductive plates 61 and 62 are preferably about .004 inches thick, resulting is a slight pliability to further conform the mating surfaces together.

Reducing connector loss is an important part of this invention. Became of the relatively large contact area between the conductive plates 61 and 62, essentially across their entire rectangular mating surfaces, the ohmic resistance across the connector 60 is held to an extremely low value. Preferably, the mating surfaces of conductive plates 61 and 62, i.e. the upper surface of lower plate 61 and the lower surface of upper plate 62, are gold plated to further reduce contact resistance and to reduce oxidation for long term maintenance of contact integrity.

The conductive plates 61 and 62 are connected to the respective open ends of resonator halves 51 and 52 by copper jumper straps 70, having the same width and thickness as the copper segments 40 in the end loops 35 and 36. The jumper straps 70 penetrate the end surfaces 31 and 32 through slots 71 formed in the latter into the hollow interior 16 of the case halves 11 and 12, respectively. In the interior 16 of case halves 11 and 12, the jumper straps 70 are bonded to the end segment 40 of each respective open end of both end loops 35 and 36. Preferably, the jumper straps 70 are integrally formed with the conductive plates 61 and 62 as one solid copper strip, bent at a right angle to pass through slots 71. The bonding of the jumper straps 70 to the segments 30 may be performed, for example, by soldering across the entire width of the jumpers 70 and segments 40, or alternately, the end segment 40, jumper strap 70 and conductive plate 61 or 62 may all be formed as one continuous copper strip as shown in Figs. 1-5.

In addition to providing an improved electrical connection, the connectors 60 according to the invention are also mechanically superior to prior connectors utilized in split coil assemblies. The conductive plates 61 and 62, while presenting a large surface area towards each other, are nearly flush with the end surfaces 31 and 32, and are therefore highly resistant to being broken off. Further, even if the conductive plates 61 and 61 are damaged, e.g. bent or dented, the "sandwiching" action employed when the connectors 60 are engaged results in an electrical contact which is largely immune to minor surface imperfections on the conductive plates 61 and 62. In fact, the compression of the conductive plates against each other would tend to straighten out damaged areas, and in that respect be in effect self-healing.

The advantages of the above described connector should be readily apparent to those skilled in the art. Due to the thoroughly solid interconnections and extremely low resistance contact, the connector 60 according to the invention has been proven experimentally to permit quadrature operation of the resonator 20 with essentially identical values of Q for both quadrature resonance modes 62 and 63.

It should also be apparent to those skilled in the art that other modifications to the above described embodiment are within the scope of this invention. For example, instead of comprising two completely separable halves, the coil assembly may alternately be "hinged" along one end to open in a clam shell fashion, in which case connectors would only be required for the opening opposite the hinge. Also, the disclosed embodiment includes four connectors 60 according to the invention (two end loops with two breaks per end loop), while other embodiments may include a greater or lesser number of connectors.

## Claims

1. A coil assembly comprising:
   a case having first and second facing surfaces, the case being movable between a closed position in which the first and second facing surfaces are in close proximity to each other and an open position in which the first and second facing surfaces are separated from each other;
   a resonator supported by the case and terminating in first and second electrically discontinuous open ends, with the first and second open ends being disposed in the vicinity of the first and second facing surfaces, respectively; and
   at least one separable connector for establishing electrical contact between the first and second resonator open ends, the connector including a first conductive plate electrically connected to the first resonator open end and disposed on the first facing surface, and a second conductive plate electrically connected to the second resonator open end and disposed on the second facing surface, with the first and second conductive plates being arranged in alignment with each other such that the first and second conductive plates are sandwiched between the first and second facing surfaces of the case when the case is in the closed position.

2. The coil assembly as recited in claim 1 which further includes a releasable latch for urging the first and second facing surfaces towards each other when the case is in the closed position and the latch is in a latched position, and for permitting separation of the first and second facing surfaces to place the case in the open position when the latch is in a released position.

3. The coil assembly as recited in claim 2 in which a resilient pad is positioned between the first facing surface and the first conductive plate so as to apply a resilient pressure holding the first and second conductive plates together when the case is in the closed position.

4. The coil assembly as recited in claim 1 in which (a) the case includes a second set of first and second facing surfaces so as to allow splitting of the case into separate first and second case halves, (b) the resonator includes a second set of first and second electrically discontinuous open ends, with the second set of first and second open ends being disposed in the vicinity of the second set of first and second facing surfaces, respectively, so as to allow splitting of the resonator into separate first and second resonator halves corresponding to the first and second case halves, and (c) the coil assembly includes a second of said at least one separable connector for establishing electrical contact between the second set of first and second resonator open ends.

5. The coil assembly as recited in claim 4 in which the resonator is a bird cage type NMR coil which includes two end rings, with each end ring terminating in two sets of first and second open ends, and in which a total of four of said at least one separable connector are included for establishing electrical contact between the first and second open ends in each set of first and second open ends on both end rings.

6. The coil assembly as recited in claim 5 in which two output signals in phase quadrature are obtained from the bird cage NMR coil.

FIG.1.

FIG.2.

FIG.3.

FIG.4.

FIG.5.